# EUROPEAN PATENT SPECIFICATION

(11) **EP 2 956 297 B1**
(45) Date of publication and mention of the grant of the patent: **27.07.2016**
(21) Application number: 14704159.4
(22) Date of filing: 13.02.2014
(51) Int. Cl.: B32B 15/085, B32B 27/32, B32B 27/10

(54) **PRINTABLE FILM FOR LAMINATION ON GRAPHIC SUPPORTS HAVING A METALLIC MATTE FINISH AND METHOD OF MANUFACTURING**
DRUCKBARE FOLIE ZUR LAMINIERUNG AUF GRAFIKTRÄGER MIT EINER METALLISCH-MATTEN OBERFLÄCHE UND HERSTELLUNGSVERFAHREN
FILM IMPRIMABLE POUR STRATIFICATION SUR SUPPORTS GRAPHIQUES AYANT UNE FINITION MATE MÉTALLIQUE ET PROCÉDÉ DE FABRICATION

(30) Priority: 13.02.2013 EP 13382042
(43) Date of publication of application: 23.12.2015
(73) Proprietor: Taghleef Industries S.L., 23680 Alcalá La Real-Jaén (ES)
(72) Inventor: MOLINA, Antonio, E-23680 Alcalá la Real Jaén (ES); DEL BARRIO PÉREZ, Javier, E-23680 Alcalá la Real Jaén (ES); LÓPEZ QUESADA, Manuel, E-23680 Alcalá la Real Jaén (ES)
(74) Representative: Elzaburu S.L.P.
(86) International application number: PCT/EP2014/052824
(87) International publication number: WO 2014/125026

(56) References cited:
- EP-A2- 0 122 495
- WO-A1-03/072353
- WO-A1-2012/039856
- US-A- 6 022 612
- US-A1- 2004 191 529
- US-A1- 2004 197 572
- US-A1- 2005 245 651
- US-A1- 2008 220 226

## Description

### FIELD OF THE INVENTION

The present invention refers to a film with a metallic matte finish suitable for being laminated on graphic supports, printed materials or without printing based on paper/cardboard in conventional wet-type lamination (with glues) and/or dry (with low temperature sealing resin) lamination, and which further displays a high capacity for being printed with conventional inks resulting in a film with excellent colours and metallic hues. The market of the finished product is that of manufacturing boxes for perfumes, covers, posters, graphic prints, etc.

### BACKGROUND OF THE INVENTION

Conventional films for laminating graphic supports or printed materials such as paper, cardboard, etc., are normally transparent films with gloss or matte finishes that are used to protect printed material. Normally the image is already contained in the graphic media and the function of the film is simply to protect said impression, providing it a gloss or matte finish, as desired. The films are normally made of biaxially-oriented polypropylene, polyester and/or polyamide, with a total thickness between 10 and 50 µ. If biaxially-oriented polypropylene is used, the film has a face with a basic surface tension (38 to 40 dynes/cm) for facilitating certain outdoor finishing works, such as varnished and printed jobs with UV curable inks and/or for anchoring hot stamp finishes. These polypropylene films usually also have additives that accompany the plastic such as lubricating greases, etc., which are not prepared for obtaining solid anchors with conventional inks, given that the purpose of the film is to protect the printed support, not to enable printing on it.

There are also films of metallized biaxially-oriented polyester ready to be printed. These polyester films have the drawback that the nature and density of the material generate many problems during the processes of lamination and the cutting/separation of the laminated supports, because the film does not tear with sufficient ease, and so requires machinery that is specially prepared for this material and which only is provided with a gloss finish.

The film object of the invention is a film based on biaxially-oriented polypropylene with matte finish, metallized on one face and coated on the other with a suitable plastic resin for printing on it. Once laminated on a paper/cardboard medium, the film can be satisfactorily printed in conventional printing processes such as offset, flexography, screen printing or rotogravure, using conventional inks for non-porous, quick drying media, such as UV curing.

When this media is printed, the finished print highlights the ink hues, generating metallized type glosses and different hues depending on the angle of vision and the light falling on the media. This effect is obtained without the need to use metallized inks, which represents a big advantage because the use of metallized inks which, besides being rare and not widely produced by ink manufacturers, has the drawback of being high priced, with few pantone colors available and, at all events, that never obtains the metallic tonalities obtained with the use of the object media of the invention.

### SUMMARY OF THE INVENTION

Consequently, one of the problems to be solved by the present invention is providing a printable film with a metallized matte finish that surpasses the drawbacks of the films known in the prior art and, in particular, that makes it possible to obtain metallic type ink hues and gloss, with colors that stand out and metallized hues, without requiring the use of metallized inks.

The inventors have discovered that the solution to this problem is to provide a biaxially oriented polypropylene substrate, transparent by contact, that is, even if it has a high opacity at the start, when it is laminated and put into contact with a printed surface the image, although it may lose some tonality, remains visible through the film. A layer of aluminium is placed on the opposite face of the printing face of this biaxial polypropylene substrate. The printing face is coated, preferably by a wet coating process, with a layer of plastic resin, preferably polar, which, after drying, has surface having a sufficiently elevated surface tension to enable the adherence on said layer of conventional inks that are commonly used in offset, flexography, screen or rotogravure type printing processes. This surface tension is at least 42 dynes/cm and preferable at least 45 dynes/cm.

Thus, in a first aspect, the invention discloses a printable film with metallized matte finish for lamination on paper and/or cardboard that comprises a biaxially oriented polypropylene substrate (1), transparent by contact, having a thickness of between 8 and 60 µ, characterized in that the film comprises, on the face of said substrate (1) opposite to the face intended to be printed, a layer (3) of aluminium and, on the face of said substrate (1) intended to be printed, a layer (2) of a plastic resin that, when dry, exhibits a surface tension of at least 42 dynes/cm.

In a second aspect, the invention discloses a process for manufacturing a printable film with metallized matte finish such as has been previously defined, which comprises at least the steps of:
a) providing a biaxially-oriented polypropylene substrate (1), transparent by contact, having a thickness of between 8 and 60 µ;
b) applying, on the face of substrate (1) opposite to the face intended to be printed, a layer (3) of aluminium and
c) applying, by means of a wet coating, on the face of substrate (1) intended to be printed, a layer (2) of a plastic resin which, when dry, exhibits a surface tension of at least 42 dynes/cm, a tension that is sufficiently high for enabling the adherence on said layer (2) of the inks that are used in offset, flexography, screen or rotogravure type printing processes.

In a third aspect, the invention discloses the use of a film as previously defined in offset, flexography, screen or rotogravure type printing processes to obtain a printable surface with a metallized matte finish.

### DETAILED DESCRIPTION OF THE INVENTION

Polypropylene is one of the materials exhibiting the worst receptibility to inks and coatings, being nearly chemically inert for the anchoring of those materials. For that reason, inks and coatings can hardly attach in a satisfactory and permanent way to this material. In order to increase this anchoring, a modification of the surface of the material is required, and one of the main parameters involved in this modification is the surface tension.

A polypropylene surface, lacking of any surface treatment, has a typical surface tension in the range of 29-33 dynes/cm. The inventors have found that, in order to obtain a satisfactory anchoring of a liquid coating to a polypropylene surface, the surface tension of the liquid should be at least 10 dynes/cm lower than the surface tension of the polypropylene. Therefore, in order to modify the surface structure of the polypropylene to make it more receptive to inks, the surface tension of the polypropylene surface should be increased.

To this end, the inventors have found that by coating the polypropylene surface with a high polarity or high surface tension plastic resin such as the acrylic, polyurethanic or styrenic resins, the surface tension of the polypropylene substrate turns out to be increased to values of at least 42 dynes/cm, thereby substantially improving its anchoring capacity for the printing inks. This increase is obtained just through the coating of the polypropylene surface with one of those resins, there being no need of any other treatment such as a corona treatments or similar on top of this coating.

Throughout the present document, the surface tension measurements have been carried out using the test method described in ASTM D2578-09 (Standard Test Method for Wetting Tension of Polyethylene and Polypropylene Films).

The following is a detailed description of the invention with reference to the attached figures.

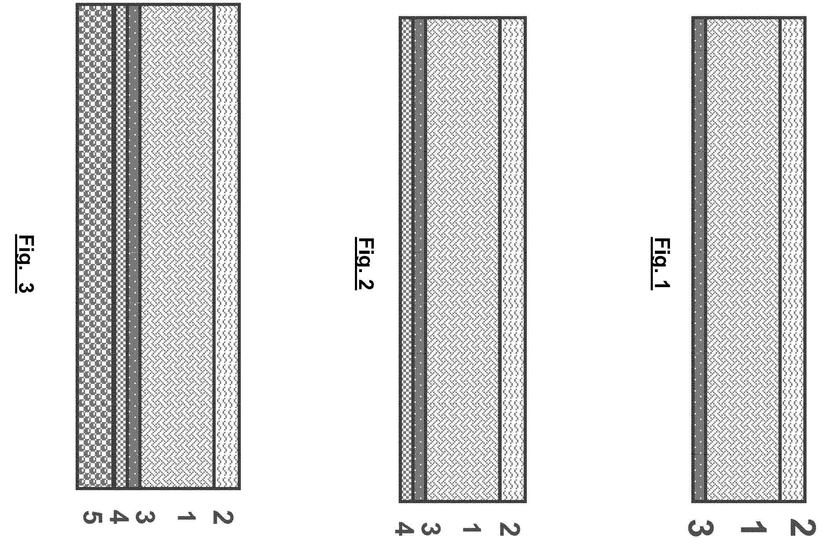

To obtain said effects and enable the printing, in a first embodiment of the invention (see Fig. 1) the film is comprised by a biaxially-oriented polypropylene substrate (1) which is at least substantially transparent by contact, that is, after it has been laminated on a printed material, manufactured by extrusion and stretched in transversal and longitudinal directions, having a thickness of between 8 to 60 µ or, more preferably, a thickness of between 10 to 40 µ. This film is coated on its bottom face, that is, the face opposite the face to be printed, with an aluminium layer (3) having a coating density of between 0.05 to 0.5 g of aluminium for each square meter of coated substrate. In preferred embodiments of this invention, this aluminium layer is applied to the substrate by means of a standard high vacuum metallization process prepared for coating plastic supports.

Furthermore, in order to obtain a solid anchoring of the inks, the face intended to be printed is coated with a layer (2) of a plastic resin, preferably polar, suitable for pre-impression, for example, of the acrylic, polyurethanic, styrenic types, etc. After being covered with the plastic resin and after drying, the surface of the resulting layer has a thickness of between 0.05 to 5 µ, and a surface tension of at least 42 dynes/cm, which is sufficiently high to enable solid anchoring of the inks for the non-porous media used in conventional printing processes; said process will be types such as offset, flexography, screen, rotogravure, etc.

Furthermore, the layer (2) can withstand the contact of a high temperature calender stack without adhering to the roller surface or altering its optical properties. This temperature is 70°C for films intended for wet lamination process, and 100°C for films intended for dry lamination processes.

In another embodiment (see Figure 2), with the aim of improving the adhesion of this film in the subsequent lamination process on a paper, cardboard, etc. support, and by means of a wet coating process, a film of an adhesion promoter (4) that has a solid anchoring over the aluminium and that is likewise suitable for adhering to plastic films is incorporated onto the outer face of the metallized layer (3), for the purpose of increasing and maintaining over time the surface tension of said face in order to guarantee the anchoring of the glues in said subsequent laminating process. The surface tension of the metallized face of the films made of biaxial polypropylene tend to be lost with time, and so it is advisable to coat the outer face of said layer with an adhesion promoter in order to prolong the useful life of the product.

In still another embodiment (see Fig. 3), in cases in which the material is intended for the dry lamination process, the film may include an additional layer (5) of a low sealing temperature polymer such as EVA, EBA, EMA, EEA, polyolefin plastomers or elastomers, etc., having a thickness ranging preferably from 8 to 30 µ. This material adheres on the aluminium layer of the film by means of an intermediate layer (4) of an adhesion promoter that is compatible with and provides a solid anchor between both materials.

### Experimental Example

In order to provide a better understanding of the invention, the following is a detailed explanation of a preferred embodiment of the invention, which is provided to give an illustrative example of the invention but which, by no means, should be considered to limit the same.

The manufacturing process begins with the manufacturing of a biaxially-oriented polypropylene substrate (1) having a thickness of 15 µ, giving it a matte finish on one of the faces and a gloss finish on the other. The matte finish, formed by the matte compound MATIF 97, has a layer thickness of 2 to 3 µ, and is produced by co-extrusion. The opposite face (the glossy face) is likewise produced by co-extrusion, and comprises a type KS357 metallizable PP terpolymer, having a layer thickness of 1 µ. For the purpose of obtaining a solid anchor of the aluminium, the PP substrate is free of anti-slip/anti-static type additives that could migrate to the surface, which could lead to anchoring problems with the aluminium.

The face of the biaxially-oriented polypropylene substrate (1) to be metallized, that is, the glossy side, is treated with a flame treatment for the purpose of increasing the surface tension of the film. After being treated its surface tension must be at least 38 dynes/cm. Next this face is metallized with an aluminium layer (3) having an optic density of 2. Said metallization is produced in a high vacuum metallizer consisting in the evaporation and condensation of the aluminium on the glossy face of biaxial polypropylene substrate (1).

After the metallization, the film is conveyed to the following coating process, in which the matte face, the one opposite the glossy face, undergoes a wet coating process with a plastic resin layer (2) of the type Polyurethane Neorez R-620, the coating layer having a thickness of 0,2 µ. The plasticizing process of this resin is carried out in a furnace, which simultaneously dries the dispersant (water) contained in said dispersion and that is added for adjusting the percentage of solids to the desired level. The final solids content of this layer is as follows:
- PU resin base (Neorez R-620): 92%
- Polyethylene wax (Aquacer 513): 8%

Alternatively, instead of this resin, it is possible to add another type of coating that provides other properties, as desired. For example, it can be coated with 2 µ of polyurethane matte in order to strengthen the matte property of the biaxial polypropylene film. This coating could be, for example a Neorez R-1010 type coating.

After being coated with any of the two options, the resulting layer of coating has a surface tension of at least 42 dynes/cm. Prior to the application of this coating, a corona treatment may be applied to the matte face of the film in order to strengthen the anchoring of said coating, given that to ensure a solid anchoring it is best to refresh the surface tension of the film with a corona treatment.

Finally, the metallized face (3) is preferably coated with another layer (5) of an adhesion promoter such as Neorez R-620. The purpose of this coating is to protect the metallized face and give the film a suitable surface for adhesion of the glues, thus improving its sliding and preventing the film from jamming. The final solids content of this layer is as follows:
- PU resin base (Neorez R-620): 92%
- Polyethylene wax (Aquacer 513): 8 %

As another alternative, if the film is prepared for dry lamination, instead of coating the metallized face (3) with an adhesion promoter of the type Neorez R-620, it may be coated with another more specific anchoring promoter for improving compatibility between the PP film and the EVA copolymer. This promoter could be, for example, Neorez R-600. After drying, the thickness of the layer of this resin is 0.2 µ. In this case the layer does not contain any anti-slip or anti-blocking agents. Next, a layer of EVA (Ethyl vinyl acetate) (5) is laminated or extruded over the R-600 promoter, the thickness of said EVA layer being 15 µ. The EVA used has a fluidity of 20 g/10 min (190°C - 2.16 kg) and has a 20% vinyl acetate content, which enables a solid anchoring of the film on the medium. After being coated, EVA face (5) is treated with an on line corona treatment to increase its surface tension to above 45 dynes/cm.

Finally, the film is spooled and cut in subsequent processes depending on the specific needs of each case. The film with this composition is ready for laminating and printing in later processes and for obtaining novel effects in relation to the printing features comprising the objects of the invention.

To proceed with the printing, the film is laminated onto a 240 g/m² basis weight white paper support. The laminating temperature for dry film ranges from 90°C to 105°C, a temperature at which a film anchor of greater than 6 N/20 mm, sufficient for these types of finish, is obtained. The printing process is done on a 4 color OFFSET printer with dryer and Sakata Ecopure fast drying ink. After 48 hours the printing is sufficiently anchored on the medium and provides a very flashy and realistic metallic finish, highlighting and providing various glosses and hue changes depending on the viewing angle and the light falling on the support. The metallic effect strengthens the clearer and less opaque hues.

## Claims

1. A printable film with metallized matte finish for lamination on paper and/or cardboard supports that comprises a biaxially-oriented polypropylene substrate (1), transparent by contact, having a thickness of between 8 and 60 µ, **characterized in that** the film further comprises, on the face of said substrate (1) opposite to the face intended to be printed, a layer (3) of aluminium and, on the face of said substrate (1) intended to be printed, a layer (2) of a plastic resin of the acrylic, polyurethanic or styrenic types that, when dry, exhibits a surface tension of at least 42 dynes/cm.

2. Film in accordance with claim 1, wherein the layer (2) of a plastic resin, when dry, exhibits a surface tension of at least 45 dynes/cm.

3. Film in accordance with any one of the previous claims, wherein the aluminium layer (3) has a coating density of between 0.05 and 0.5 g of aluminium for each square meter of substrate (1).

4. Film in accordance with any one of the previous claims, wherein the film further comprises, on the outer face of the aluminium layer (3), an additional layer (4) of an adhesion promoter over the aluminium which, when dry, exhibits a surface tension of at least 38 dynes/cm, for facilitating the subsequent laminating process on the paper or cardboard support in the laminating processes with glues (wet process).

5. Film in accordance with any of previous claims 1 to 3, wherein the film further comprises, on the outer face of the aluminium layer (3), an additional layer (5) of a low sealing temperature plastic resin that is bound to the aluminium layer (3) through an intermediate layer (4) comprising an adhesion promoter over the aluminium (3) and resin (5) layers, for facilitating the subsequent process of laminating on the paper or cardboard supports during the dry lamination process.

6. Film in accordance with claim 5, wherein the low sealing temperature plastic resin is a resin of the type EVA, EBA, EMA, EEA, polyolefin plastomers or elastomers.

7. Procedure for manufacturing a printable film with metallized matte finish in accordance with any of the previous claims, **characterized in that** it comprises the steps of:
a. providing a biaxially-oriented polypropylene substrate (1), transparent by contact, having a thickness of between 8 and 60 µ;
b. applying, on the face of substrate (1) opposite to the face intended to be printed, a layer (3) of aluminium, and
c. applying, by means of a wet coating process, on the face of the substrate (1) intended to be printed, a layer (2) of a plastic resin of the acrylic, polyurethanic or styrenic types which, when dry, exhibits a surface tension of at least 42 dynes/cm.

8. Procedure in accordance with claim 7, wherein the aluminium layer (3) is applied on the substrate (1) by means of a high vacuum metallization process.

9. Procedure in accordance with previous claims 7 or 8, which further comprises the additional step of applying over the aluminium layer (3), by means of a wet process, a layer (4) having an adhesion promoter over the aluminium which, when dry, exhibits a surface tension of at least 38 dynes/cm, for facilitating and guaranteeing over time the posterior laminating process on a paper or cardboard media during the wet lamination processes with glue.

10. Procedure in accordance with claims 7 or 8, comprising the additional stage of applying, over the aluminium layer (3), a layer (5) of low sealing temperature plastic resin, that is bound to the aluminium layer (3) by means of an intermediate layer (4) comprising an adhesion promoter over the aluminium (3) and resin layers (5), for facilitating the subsequent process of laminating on the media of paper or cardboard during the dry lamination process.

11. Use of a film in accordance with any one of previous claims 1 to 6 in the offset, flexography, screen or rotogravure type printing procedures that use inks for non-porous supports, in order to obtain a printable surface of metallized mate finish.

## Patentansprüche

1. Eine bedruckbare Folie mit einer metallisierten, matten Oberflächengüte zur Kaschierung auf Papier- und/oder Pappträger, die ein biaxial ausgerichtetes, bei Kontakt transparentes Polypropylen-Substrat (1) mit einer Dicke zwischen 8 und 60 µ umfasst, **dadurch gekennzeichnet, dass** die Folie weiterhin auf der der zu bedruckenden Oberfläche gegenüberliegenden Oberfläche dieses Trägers (1) eine Schicht (3) aus Aluminium und auf der zu bedruckenden Oberfläche dieses Trägers (1) eine Schicht (2) aus Kunststoffharz von der Art eines Acryl-, Polyurethan- oder Styrolharzes umfasst, die im trockenen Zustand eine Oberflächenspannung von mindestens 42 Dyn/cm aufweist.

2. Folie nach Anspruch 1, wobei die Schicht (2) aus Kunststoffharz im trockenen Zustand eine Oberflächenspannung von mindestens 45 Dyn/cm aufweist.

3. Folie nach jedem der vorherigen Ansprüche, wobei die Aluminiumschicht (3) eine Beschichtungsdicke zwischen 0,05 und 0,5 g Aluminium pro Quadratmeter Substrat (1) besitzt.

4. Folie nach jedem der vorherigen Ansprüche, wobei die Folie weiterhin an der Außenfläche der Aluminiumschicht (3) eine zusätzliche Schicht (4) eines Haftvermittlers über dem Aluminium umfasst, die im trockenen Zustand eine Oberflächenspannung von mindestens 38 Dyn/cm aufweist, um die anschließende Kaschierung auf den Papier- oder Pappträger beim Kaschierverfahren mit Klebern (Nassverfahren) zu erleichtern.

5. Folie nach jedem der vorherigen Ansprüche 1 bis 3, wobei die Folie weiterhin an der Außenfläche der Aluminiumschicht (3) eine zusätzliche Schicht (5) aus einem Kunststoffharz mit einer niedrigen Versiegelungstemperatur umfasst, die über eine Zwischenschicht (4) mit der Aluminiumschicht (3) verbunden ist und über den Aluminium- (3) und Harzschichten (5) einen Haftvermittler umfasst, um die anschließende Kaschierung auf den Papier- oder Pappträger während des Trockenkaschierverfahrens zu erleichtern.

6. Folie nach Anspruch 5, wobei das Kunststoffharz mit niedriger Versiegelungstemperatur ein Harz von der Art eines EVA-, EBA-, EMA-, EEA-Harzes, eines Polyolefin-Plastomers oder Elastomers ist.

7. Verfahren zur Herstellung einer bedruckbaren Folie mit einer metallisierten, matten Oberflächengüte nach jedem der vorherigen Ansprüche, **dadurch gekennzeichnet, dass** dieses die folgenden Schritte umfasst:
a. Bereitstellung eines biaxial ausgerichteten, bei Kontakt transparenten Polypropylen-Substrats (1) mit einer Dicke zwischen 8 und 60 µ;
b. Aufbringung einer Schicht (3) aus Aluminium auf der der zu bedruckenden Oberfläche gegenüberliegenden Trägeroberfläche (1); und
c. Aufbringung einer Schicht (2) aus Kunststoffharz von der Art eines Acryl-, Polyurethan- oder Styrolharzes auf der zu bedruckenden Trägeroberfläche (1) mittels eines Nassbeschichtungsverfahrens, die im trockenen Zustand eine Oberflächenspannung von mindestens 42 Dyn/cm aufweist.

8. Verfahren nach Anspruch 7, bei dem die Aluminiumschicht (3) mittels eines Hochvakuum-Metallisierungsverfahrens auf das Substrat (1) aufgebracht wird.

9. Verfahren nach den vorstehenden Ansprüchen 7 oder 8, das weiterhin den zusätzlichen Schritt der Aufbringung einer Schicht (4) über der Aluminiumschicht (3) mittels eines Nassverfahrens umfasst, die einen Haftvermittler über dem Aluminium besitzt und im trockenen Zustand eine Oberflächenspannung von mindestens 38 Dyn/cm aufweist, um die anschließende Kaschierung auf ein Papier- oder Pappmedium während des Nasskaschierverfahrens mit Klebern im Verlauf der Zeit zu erleichtern und sicherzustellen.

10. Verfahren nach den Ansprüchen 7 oder 8, das die zusätzliche Phase der Aufbringung einer Schicht (5) aus einem Kunststoffharz mit einer niedrigen Versiegelungstemperatur über der Aluminiumschicht (3) umfasst, die über eine Zwischenschicht (4) mit der Aluminiumschicht (3) verbunden ist und über den Aluminium- (3) und Harzschichten (5) einen Haftvermittler umfasst, um die anschließenden Kaschierung auf das Papier- oder Pappmedium während des Trockenkaschierverfahrens zu erleichtern.

11. Verwendung der Folie nach einem der vorherigen Ansprüche 1 bis 6 bei Offsetdruck-, Flexodruck-, Siebdruck- oder Rotationstiefdruckverfahren, die Druckfarben für nicht poröse Substrate einsetzen, um eine bedruckbare Oberfläche mit einer metallisierten, matten Oberflächengüte zu erhalten.

## Revendications

1. Un film imprimable avec fini mat métallisé pour contrecollage sur supports en papier et/ou carton qui comprend un substrat de polypropylène bi-axialement orienté (1), transparent par contact, ayant une épaisseur comprise entre 8 et 60 µ, **caractérisé en ce que** le film comprend en outre, sur la face dudit substrat (1) opposée à la face destinée à être imprimée, une couche (3) d'aluminium et, sur la face dudit substrat (1) destinée à être imprimée, une couche (2) d'une résine plastique des types acrylique, polyuréthanique ou styrénique qui, lorsqu'elle est sèche, présente une tension de surface d'au moins 42 dynes/cm.

2. Film conformément à la revendication 1, où la couche (2) d'une résine plastique, lorsqu'elle est sèche, présente une tension de surface d'au moins 45 dynes/cm.

3. Film conformément à n'importe laquelle des revendications précédentes, où la couche d'aluminium (3) a une densité de revêtement comprise entre 0,05 et 0,5 g d'aluminium par mètre carré de substrat (1).

4. Film conformément à n'importe laquelle des revendications précédentes, où le film comprend en outre, sur la face externe de la couche d'aluminium (3), une couche supplémentaire (4) d'un promoteur d'adhésion sur l'aluminium qui, lorsqu'elle est sèche, présente une tension de surface d'au moins 38 dynes/cm, pour faciliter le processus de contrecollage ultérieur sur le support en papier ou carton dans les procédés de contrecollage avec colles (procédé humide).

5. Film conformément à n'importe laquelle des revendications 1 à 3 précédentes, où le film comprend en outre, sur la face externe de la couche d'aluminium (3), une couche supplémentaire (5) d'une résine plastique à basse température d'accrochage qui est liée à la couche d'aluminium (3) via une couche intermédiaire (4) comprenant des couches de promoteur d'adhésion sur l'aluminium (3) et de résine (5), pour faciliter le processus ultérieur de contrecollage sur les supports en papier ou carton durant le procédé de contrecollage à sec.

6. Film conformément à la revendication 5, où la résine plastique à basse température d'accrochage est une résine de type EVA, EBA, EMA, EEA, plastomères ou élastomères de polyoléfines.

7. Procédé de fabrication d'un film imprimable avec fini mat métallisé conformément à n'importe laquelle des revendications précédentes, **caractérisé en ce qu'**il comprend les étapes consistant à :
a. fournir un substrat de polypropylène bi-axialement orienté (1), transparent par contact, ayant une épaisseur comprise entre 8 et 60 µ ;
b. appliquer sur la face de substrat (1) opposée à la face destinée à être imprimée, une couche (3) d'aluminium, et
c. appliquer, au moyen d'un procédé de revêtement humide, sur la face du substrat (1) destinée à être imprimée, une couche (2) d'une résine plastique des types acrylique, polyuréthanique ou styrénique qui, lorsqu'elle est sèche, présente une tension de surface d'au moins 42 dynes/cm.

8. Procédure conformément à la revendication 7, où la couche d'aluminium (3) est appliquée sur le substrat (1) au moyen d'un procédé de métallisation à vide poussé.

9. Procédure conformément à n'importe laquelle des revendications 7 ou 8 précédentes, qui comprend en outre l'étape supplémentaire consistant à appliquer sur la couche d'aluminium (3), au moyen d'un procédé humide, une couche (4) ayant un promoteur d'adhésion sur l'aluminium qui, lorsqu'elle est sèche, présente une tension de surface d'au moins 38 dynes/cm, pour faciliter et garantir dans le temps le procédé de contrecollage postérieur sur un support en papier ou carton durant les procédés de contrecollage humide avec colle.

10. Procédure conformément aux revendications 7 ou 8, comprenant l'étape supplémentaire consistant à appliquer sur la couche d'aluminium (3), une couche (5) de résine plastique à basse température d'accrochage, qui est liée à la couche d'aluminium (3) via une couche intermédiaire (4) comprenant des couches de promoteur d'adhésion sur l'aluminium (3) et de résine (5), pour faciliter le processus ultérieur de contrecollage sur les supports en papier ou carton durant le procédé de contrecollage à sec.

11. Utilisation d'un film conformément à n'importe laquelle des revendications 1 à 6 précédentes dans les procédures d'impression de type offset, flexographie, sérigraphie ou rotogravure qui utilisent des encres pour supports non poreux, afin d'obtenir une surface imprimable fini mat métallisé.
